# EUROPÄISCHE PATENTSCHRIFT

(11) **EP 4 069 882 B1**
(45) Veröffentlichungstag und Bekanntmachung des Hinweises auf die Patenterteilung: **13.03.2024**
(21) Anmeldenummer: 20824896.3
(22) Anmeldetag: 01.12.2020
(51) Int. Cl.: C23C 16/455, C23C 16/458

(54) **GASEINLASSVORRICHTUNG FÜR EINEN CVD-REAKTOR**
GAS INLET DEVICE FOR A CVD REACTOR
DISPOSITIF D'ADMISSION DE GAZ D'UN RÉACTEUR CVD

(30) Priorität: 04.12.2019 DE 102019133023
(43) Veröffentlichungstag der Anmeldung: 12.10.2022
(73) Patentinhaber: Aixtron SE, 52134 Herzogenrath (DE)
(72) Erfinder: EICKELKAMP, Martin, 52146 Würselen (DE)
(74) Vertreter: Grundmann, Dirk
(86) Internationale Anmeldenummer: PCT/EP2020/084104
(87) Internationale Veröffentlichungsnummer: WO 2021/110670

(56) Entgegenhaltungen:
- DE-A1- 10 247 921
- DE-A1-102005 055 468
- DE-A1-102011 002 145
- DE-A1-102014 104 218

## Beschreibung

### Gebiet der Technik

Die Erfindung betrifft eine Gaseinlassvorrichtung für einen CVD-Reaktor mit mehreren übereinander angeordneten Gaseinlassbereichen, von denen jeder Gasaustrittsöffnungen aufweist, durch die ein Prozessgas in eine Prozesskammer des CVD-Reaktors eingespeist wird. Durch jeden Gaseinlassbereich wird jeweils nur ein Prozessgas in die Prozesskammer eingeleitet.

Die Erfindung betrifft ferner einen mit einer derartigen Gaseinlassvorrichtung ausgerüsteten CVD-Reaktor und ein Verfahren zum Einspeisen von Prozessgasen in eine Prozesskammer.

### Stand der Technik

Eine Gaseinlassvorrichtung mit mehreren vertikal übereinander angeordneten Gasaustrittszonen, die vertikal übereinander angeordnet sind und jeweils über eine Zuleitung mit einer Gasquelle verbunden sind, beschreiben die DE 10 2008 055 582 A1 und DE 10 2014 104 218 A1 und DE10247921.

Für die Durchführung verschiedener Prozesse, in denen verschiedene Schichten, insbesondere Schichten aus mehreren Komponenten, insbesondere III-V-Komponenten abgeschieden werden, werden Gaseinlassvorrichtungen verwendet, deren vertikal übereinander angeordnete Gasaustrittszonen verschiedene Höhen besitzen.

### Zusammenfassung der Erfindung

Der Erfindung liegt die Aufgabe zugrunde, ein Verfahren zum Einspeisen eines Prozessgases in einen CVD Reaktor anzugeben und einen CVD Reaktor und insbesondere das ihm zugehörige Gasmischsystem hierzu weiterzubilden.

Gelöst wird die Aufgabe durch die in den Ansprüchen angegebene Erfindung, wobei die Unteransprüche nicht nur vorteilhafte Weiterbildungen der nebengeordneten Ansprüche darstellen, sondern auch eigenständige Lösungen der Aufgabe.

Die Erfindung sieht Maßnahmen vor, mittels denen in zumindest eines der Gasverteilvolumina wahlweise ein anderes Prozessgas eingespeist werden kann. Üblicherweise besitzt eine Gaseinlassvorrichtung drei bis fünf übereinander angeordnete Gaseinlassbereiche. Durch einen obersten und einen untersten Gaseinlassbereich kann ein Hydrid einer III-Verbindung, beispielsweise Arsin, Phosphin oder Ammoniak zusammen mit einem Trägergas, beispielsweise Wasserstoff, in die Prozesskammer eingespeist werden. Durch einen dazwischenliegenden, mittleren Gaseinlassbereich kann eine metallorganische Verbindung, insbesondere eine III-MO-Verbindung, ebenfalls mit einem Trägergas in die Prozesskammer eingespeist werden. Die III-Verbindung und die V-Verbindung können sich auf der beheizten Oberfläche eines Suszeptors zerlegen. Die Zerlegungsprodukte können unter Bildung einer III-V-Schicht auf einem in der Prozesskammer angeordneten Substrat abgeschieden werden. Bei voneinander verschiedenen Prozessen werden erfindungsgemäß mehrere Gasverteilvolumina und insbesondere mehrere unmittelbar aneinander angrenzende Gasverteilvolumina zu einem Gaseinlassbereich, durch den dasselbe Prozessgas in die Prozesskammer fließen kann, zusammen geschaltet. Hierdurch lässt sich die Höhe der Gaseinlassbereiche, durch die dasselbe Prozessgas in die Prozesskammer fließt, variieren. Durch eine oberste Gasaustrittszone und/oder durch eine unterste Gasaustrittszone, also eine Gasaustrittszone, die einer Prozesskammerdecke oder die einem Suszeptor unmittelbar benachbart ist, kann auch während eines Abscheidungsprozesses ein Inertgas austreten, um die Oberfläche des Suszeptors und/oder die Oberfläche der Prozesskammerdecke gegen eine parasitäre Abscheidung zu schützen. Es ist insbesondere vorgesehen, dass jeder Gaseinlassbereich, durch den dasselbe Prozessgas fließt, von mindestens einer, bevorzugt zwei Gasaustrittszonen gebildet ist. Eine erfindungsgemäße Gaseinlassvorrichtung kann vorzugsweise mindestens fünf, sieben, neun, zehn oder zwölf jeweils durch einen Boden voneinander getrennte Gasverteilvolumina aufweisen, wobei jedes Gasverteilvolumen eine Gasaustrittszone ausbildet und mehrere Gasaustrittszonen zu einem Gaseinlassbereich zur Einspeisung desselben Prozessgases zusammengeschaltet sind. Wobei insbesondere vorgesehen ist, dass mehrere Gasverteilvolumina in unterschiedlichen Kombinationen zusammengeschaltet werden. In einer Variante der Erfindung wird vorgeschlagen, dass in jedes Gasverteilvolumen eine dem jeweiligen Gasverteilvolumen individuell zugeordnete Zuleitung mündet. Dabei kann die Zuleitung eine einzige Mündung aufweisen, die in das Gasverteilvolumen mündet. In jede der Zuleitungen kann eine Gasleitung münden. Die Gasleitungen können mit mehreren Ventilen, die öffenbar und schließbar sind, wahlweise mit einer aus einer Vielzahl von Speiseleitungen verbunden sein. In jede Speiseleitung kann ein anderes Gas, beispielsweise ein Inertgas oder eines der Prozessgase eingespeist werden. Durch Schalten der Ventile kann somit das Prozessgas in eine unterschiedliche Kombination von Gasverteilvolumina eingespeist werden und so aus unterschiedlichen Kombinationen von Gasaustrittszonen austreten. Die Vielzahl der Gasaustrittszonen beziehungsweise Gasverteilvolumina kann in mehrere Gruppen aufgeteilt werden. Eine Gruppe kann beispielsweise eine Vielzahl von an dem Prozesskammerboden angrenzenden Gasaustrittszonen aufweisen und/oder eine Vielzahl von an die Prozesskammerdecke angrenzenden Gasaustrittszonen aufweisen. Eine zweite Gruppe kann beispielsweise eine Vielzahl in der Mitte der Prozesskammer angeordneter Gasaustrittszonen aufweisen. Eine Gruppe von Gasaustrittszonen kann jeweils einen Gaseinlassbereich ausbilden, wobei die Gasaustrittszonen, die zu einer Gruppe gehören, unmittelbar aneinandergrenzen und durch die Gasaustrittszonen derselben Gruppe jeweils dasselbe Prozessgas oder Inertgas in die Prozesskammer austritt. Zwei benachbarte Gruppen, durch deren Gasaustrittszonen jeweils ein anderes Gas in die Prozesskammer austritt, grenzen derart aneinander, dass die an der Grenze angeordneten Gasaustrittszonen durch Umschalten der Ventile wahlweise der einen oder der anderen der an der Grenze aneinander angrenzenden Gruppen zugeordnet werden können. Dabei können Gasaustrittszonen einem Grenzbereich zugeordnet sein und die einem jeweiligen Grenzbereich zugeordneten Gasaustrittszonen zugeordneten Gasleitungen wahlweise mit verschiedenen Speiseleitungen verbindbar sein. Gasleitungen von Gasaustrittszonen, die außerhalb eines Grenzbereichs angeordnet sind, also keinem Grenzbereich zugeordnet sind, können hingegen nur mit einer Speiseleitung verbunden sein. Hierdurch ist es möglich, dass Gasaustrittszonen, die in einem Grenzbereich angeordnet sind, wahlweise der einen oder der anderen im Grenzbereich aneinander angrenzenden Gruppen zugeordnet werden können. Diese Gasaustrittszonen können somit zur Vergrößerung oder Verkleinerung eines Gaseinlassbereiches zum Einspeisen jeweils desselben Prozessgases verwendet werden. Die Höhe der Gaseinlassbereiche kann somit durch Umschalten von Ventilen, mit denen Speiseleitungen mit Gasleitungen verbunden sind, vergrößert oder verkleinert werden. Hier können die Umschaltelemente in Form von Ventilen außerhalb der Gaseinlassvorrichtung und insbesondere außerhalb des Reaktors angeordnet sein. Die Umschaltelemente sind hier Teile eines Gasmischsystems. Alternativ dazu können die Umschaltelemente aber auch im Reaktor und insbesondere in der Gaseinlassvorrichtung angeordnet sein. In einer Variante der Erfindung ist vorgesehen, dass die Zuleitungen von Rohren ausgebildet sind. Die Rohre haben Öffnungen, die in ein Gasverteilvolumen münden. Gemäß dieser Variante können die Rohre verlagert werden derart, dass ihre Öffnungen wahlweise in voneinander verschiedene Gasverteilvolumina münden. Dies kann durch eine axiale Verlagerung eines Rohres oder durch eine Drehung eines Rohres erfolgen. Es können Anschläge vorgesehen sein, an die das Rohr jeweils anschlägt, wenn die Öffnung vollständig in einem Gasverteilvolumen mündet. Es können ferner Öffnungen zwischen zwei Gasverteilvolumina vorgesehen sein, die mittels eines Verschlusselementes wahlweise geöffnet oder geschlossen werden können, so dass ein in eines der beiden Gasverteilvolumina eingespeistes Prozessgas durch die Öffnung in ein anderes Gasvolumen strömen kann. Eine von einem Rohr ausgebildete Zuleitung kann auch mehrere Öffnungen aufweisen, die durch eine Verlagerung des Rohres, beispielsweise durch Drehen oder lineares Verschieben des Rohres, in einem Außenrohr verschließbar sind. Bei einer derartigen Anordnung, bei der die Umschaltelemente in der Gaseinlassvorrichtung angeordnet sind, kann eine Zuleitung wahlweise in verschiedene Gasverteilvolumina münden. Es kann vorgesehen sein, dass eine Zuleitung gleichzeitig in mehrere Gasverteilvolumina mündet. Es kann aber auch vorgesehen sein, dass in ein Gasverteilvolumen gar keine mit einer Gasleitung verbundene Zuleitung mündet, sondern dass das Gasverteilvolumen wahlweise durch Schließen oder Öffnen einer Durchtrittsöffnung mit einem benachbarten Gasverteilvolumen strömungsverbunden werden kann. Hierzu sind bevorzugt von außerhalb des Reaktors bzw. der Gaseinlassvorrichtung betätigbare mechanische Betätigungselemente vorgesehen, mit denen Zuleitungsrohre oder Verschlusselemente räumlich verlagert werden können.

### Kurze Beschreibung der Zeichnungen

Ausführungsbeispiele der Erfindung werden nachfolgend beigefügter Zeichnungen erläutert. Es zeigen:
- Fig. 1: schematisch einen CVD Reaktor mit einer Gaseinlassvorrichtung 10 mit fünf übereinander angeordneten Gasaustrittszonen Z1 bis Z5, wobei jede der Gasaustrittszonen Z1 bis Z5 individuell mit einer Zuleitung und einer Gasleitung L1 bis L5 verbunden ist, wobei die Gasleitungen L1 bis L5 in einer in den nachfolgenden Figuren beschriebenen Weise wahlweise mit Speiseleitungen G1 bis G4 strömungsverbindbar sind,
- Fig. 2: schematisch ein erstes Ausführungsbeispiel einer Gaseinlassvorrichtung 10 mit zwölf übereinander angeordneten Gasaustrittszonen Z1 bis Z 12, oberhalb der Gaseinlassvorrichtung 10 ist schematisch ein Bereich eines Gasmischsystems dargestellt, in dem Gasleitungen L1 bis L 12 wahlweise mittels Ventilen 20 mit Speiseleitungen G1 bis G4 verbunden werden können, wobei die offenen Kreise gesperrte Ventile und die gefüllten Kreise geöffnete Ventile darstellen, sodass sich in diesem Ausführungsbeispiel drei Gaseinlassbereiche E1 bis E3 ergeben,
- Fig. 3: schematisch ein zweites Ausführungsbeispiel in einer Darstellung gemäß Figur 2, wobei sich die Gasauslassbereiche E1 bis E3 hinsichtlich der Verbindbarkeit mit Gasleitungen unterscheiden,
- Fig. 4: schematisch ein drittes Ausführungsbeispiel in einer Darstellung gemäß Figur 2, mit fünf Gasauslassbereichen E1 bis E5,
- Fig. 5: ein viertes Ausführungsbeispiel der Erfindung in einer modifizierten Darstellung des Gasmischsystems, wobei zu den Ventilen 20 Massenflusscontroller 27 dargestellt sind, mit denen ein Massenfluss eines Prozessgases oder eines Inertgases zu den Ventilen 20 einstellbar ist,
- Fig. 6: einen Ausschnitt aus einer Gaseinlassvorrichtung 10 eines fünften Ausführungsbeispiels in einer ersten Betriebsstellung, in der eine Mündung 19 einer Zuleitung 18 in ein oberes Gasverteilvolumen 17 mündet,
- Fig. 7: eine Darstellung gemäß Figur 6 in einer zweiten Stellung, in der die Mündung 19 in ein unteres Gasverteilvolumen 17' mündet,
- Fig. 8: ein sechstes Ausführungsbeispiel in einer ersten Stellung, in der ein Verschlusselement 25 eine Öffnung 22 in einem Boden 14 zwischen einem oberen Gasverteilvolumen 17' und einem unteren Gasverteilvolumen 17 schließt,
- Fig. 9: das sechste Ausführungsbeispiel in einer zweiten Stellung, in der die Öffnung 22 geöffnet ist,
- Fig. 10: ein siebtes Ausführungsbeispiel, bei dem zwei Öffnungen 22, 22' in Böden 14 aneinander angrenzender Gasverteilvolumina 17, 17' durch vertikalen Hub eines Verschlusselementes 25 wechselweise geschlossen werden können,
- Fig. 11: ein achtes Ausführungsbeispiel, bei dem Gasaustrittsöffnungen 19 durch Rotation geöffnet oder geschlossen werden können,
- Fig. 12: einen Schnitt gemäß Linie XII-XII in Figur 11 in einer ersten Stellung und
- Fig. 13: den Schnitt gemäß Figur 12 in einer zweiten Stellung.

### Beschreibung der Ausführungsformen

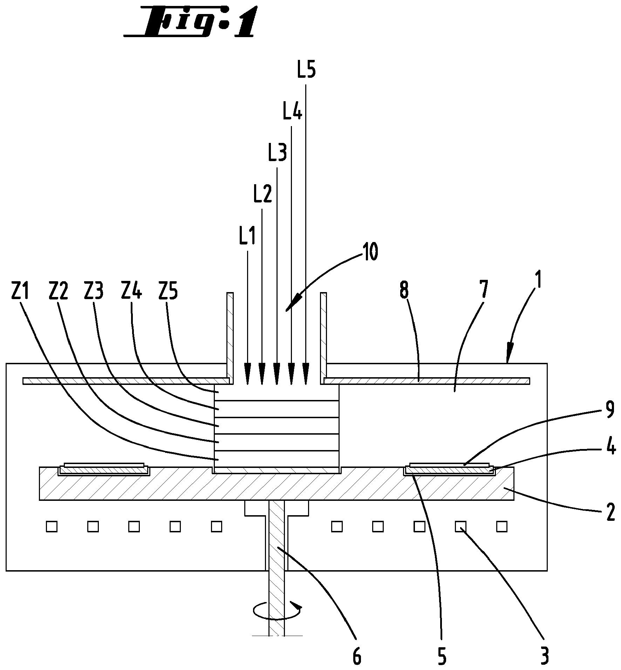

Die Ausführungsbeispiele betreffen Gaseinlassvorrichtungen mit zumindest fünf, sieben, neun, elf oder zwölf vertikal übereinander angeordneten Gasaustrittszonen Z1 bis Z12, in die wahlweise verschiedene Gase, insbesondere Prozessgase oder Inertgase eingespeist werden können. Eine Gaseinlassvorrichtung 10 kann beispielsweise in einem CVD-Reaktor, wie er in der Figur 1 schematisch dargestellt ist, verwendet werden. Der CVD-Reaktor besitzt ein Reaktorgehäuse 1, welches gasdicht ist. Innerhalb des Reaktorgehäuses 1 befindet sich ein insbesondere aus Graphit gefertigter Suszeptor 2, der ein oder mehrere Substrate 9 trägt, die in einer Prozesskammer 7 des CVD-Reaktors mit ein oder mehreren Schichten, insbesondere III-V-Schichten beschichtet werden sollen. Der Suszeptor 2 wird hierzu von unten mittels einer Heizeinrichtung 3, insbesondere einer RF-Heizung beheizt. Der Suszeptor 2 kann mittels eines drehbaren Schaftes 6 um eine Achse drehangetrieben werden. Während der Suszeptor 2 die Prozesskammer 7 nach unten begrenzt, begrenzt eine Prozesskammerdecke 8 die Prozesskammerdecke 7 nach oben. Beim Ausführungsbeispiel besitzt der Suszeptor 2 zur Prozesskammer 7 hin offene Taschen, in denen jeweils ein Substrathalter 4 angeordnet ist, der ein oder mehrere Substrate 9 tragen kann. Mittels nicht dargestellter Spülgasleitungen kann in die Tasche 5 ein Spülgas eingespeist werden, welches den Substrathalter schwebend in einer Drehung hält. Im Zentrum der Prozesskammer 7 befindet sich eine Gaseinlassvorrichtung 10, wie sie in den Zeichnungen dargestellt ist.

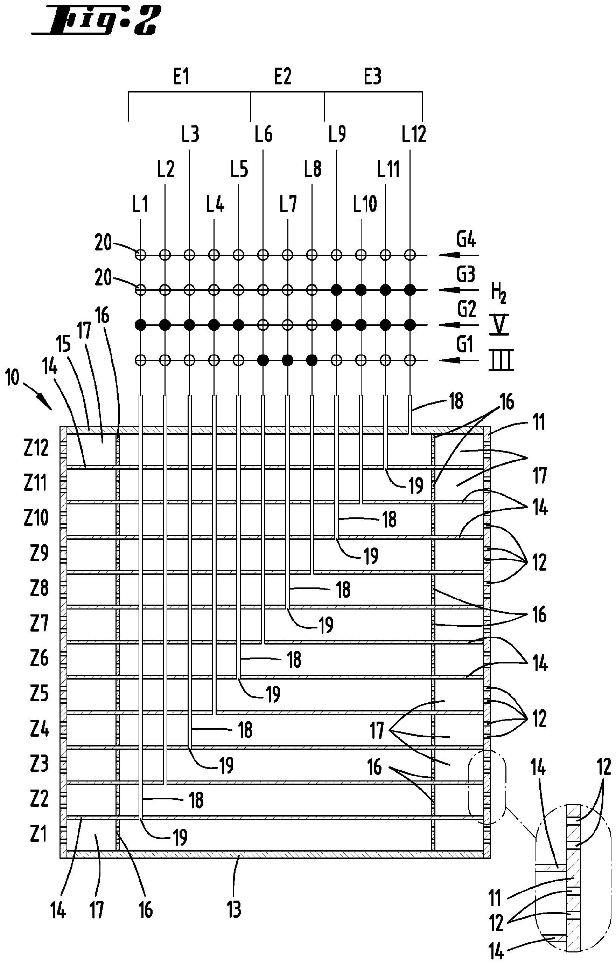

Die in der Figur 2 dargestellte Gaseinlassvorrichtung 10 besitzt zwölf übereinander angeordnete Gasaustrittszonen Z1 bis Z12, wobei jede der Gasaustrittszonen dieselbe Höhe besitzt. Die Gasaustrittszonen Z1 bis Z12 können aber voneinander verschiedene Höhen besitzen. Eine unterste Gasaustrittszone Z1 ist nach unten hin durch einen Boden 13 begrenzt. Sie ist nach oben hin durch einen Boden 14 zu einer benachbarten Gasaustrittszone Z2 begrenzt. Über der Gasaustrittszone Z2 sind jeweils durch einen Boden 14 voneinander getrennt weitere Gasaustrittszonen Z3 bis Z12 angeordnet. Die oberste Gasaustrittszone Z12 besitzt eine Decke 15.

Jede der Gasaustrittszonen besitzt eine rings umschlossene und von den parallel zueinander verlaufenden Böden 14 abgetrennte Kammer, die ein Gasverteilvolumen 17 ausbildet. Das Gasverteilvolumen 17 wird von einer sich auf einer Zylindermantelfläche erstreckenden Gasaustrittswand 11 begrenzt. Die Gasaustrittswand 11 besitzt eine Vielzahl von Gasaustrittsöffnungen 12, durch die in das Gasverteilvolumen 17 eingespeistes Gas in Radialrichtung, bezogen auf eine Achse der Gaseinlassvorrichtung 10, austreten kann.

Es ist eine Vielzahl von Zuleitungen 18 vorgesehen. Diese können von Röhrchen ausgebildet sein. Jede Zuleitung 18 besitzt eine Mündung 19, die in ein Gasverteilvolumen 17 mündet. Die Zuleitungen 18 münden in einem Zentralbereich in das Gasverteilvolumen 17. Der Zentralbereich des Gasvolumens 17 ist von einer Druckbarriere 16 umgeben, um einen gleichmäßigen Austritt des Prozessgases in azimutaler Richtung zu erreichen. Die Druckbarriere 16 kann von einer sich auf einer Kreisbogenlinie erstreckenden Wand ausgebildet sein, die parallel zur Gasaustrittswand 11 verläuft.

Jede der Zuleitungen 18 ist mit einer Gasleitung L1 bis L12 verbunden. Die Gasleitungen L1 bis L12 sind einem Gasmischsystem zugeordnet. Dieses ist in der Figur 2 schematisch dargestellt. Dort kreuzen die parallel dargestellten Gasleitungen L1 bis L12 vier Speiseleitungen G1 bis G4. An den Kreuzungsstellen sind mit offenen Kreisen geschlossene Ventile und mit gefüllten Kreisen offene Ventile dargestellt, mit denen die Gasleitungen L1 bis L12 an den Kreuzungsstellen mit den Speiseleitungen G1 bis G4 verbunden sind. Jede Gasleitung L1 bis L12 ist im Ausführungsbeispiel mit jeder der Speiseleitungen G1 bis G4 über ein Ventil verbunden, so dass in die Gasverteilvolumina 17 jedes der Prozessgase oder Inertgase eingespeist werden kann. Bei dem in der Figur 2 dargestellten Ausführungsbeispiel kann die Speiseleitung G3 mit einem Trägergas, beispielsweise H₂, N₂ oder Ar gespeist werden. Die Speiseleitung G2 kann mit Ammoniak oder einem anderen Hydrid gespeist werden. Die Speiseleitung G1 kann mit Trimethylaluminium oder mit einer anderen metallorganischen III-Verbindung gespeist werden.

Die Ventile 20 sind so geschaltet, dass sich drei Gaseinlassbereiche E1, E2, E3 ausbilden. Ein erster Gaseinlassbereich E1 wird von den Gasaustrittszonen Z1 bis Z5 gebildet. Durch die Gasaustrittsöffnungen dieses Gaseinlassbereichs E1 strömt eine V-Verbindung in die Prozesskammer. Ein zweiter Gaseinlassbereich E2 wird von den Gasaustrittszonen Z6 bis Z8 gebildet. Durch die diesem Gaseinlassbereich E2 zugeordneten Gasaustrittsöffnungen 12 strömt eine III-Verbindung in die Prozesskammer. Die Gasaustrittszonen Z9 bis Z12 bilden einen dritten Gaseinlassbereich E3 aus, durch den ebenfalls eine V-Verbindung in die Prozesskammer strömt. Hier wird in den dritten Gaseinlassbereich E3 zusätzlich Wasserstoff eingespeist.

Durch eine Änderung der Ventilstellung, beispielsweise des Ventils, welches die Speiseleitung G2 mit der Gasleitung L5 verbindet, kann der Gaseinlassbereich E1 verkleinert und der Gaseinlassbereich E2 vergrößert werden. Durch eine Änderung der Ventilstellung der Ventile 20 im Schnittpunkt der Speiseleitung G2 mit der Gasleitung L1 und im Schnittpunkt der Speiseleitung G3 mit der Gasleitung L1 kann in die Gasaustrittszone Z1 ein Inertgas eingespeist werden. Durch eine Änderung der Ventilstellung der Ventile 20 im Schnittpunkt der Gasleitung L12 und Speiseleitung G2 kann erreicht werden, dass in die Gasaustrittszone Z12 nur ein Inertgas eingespeist wird. Die geöffneten Ventile an den Schnittstellen der Speiseleitung G3 und den Gasleitungen L9, L10, L11 und L12 bewirken eine Verdünnung des in den Gaseinlassbereich E3 eingespeisten Prozessgases. Durch Schließen dieser Ventile kann die verdünnende Wirkung aufgehoben werden.

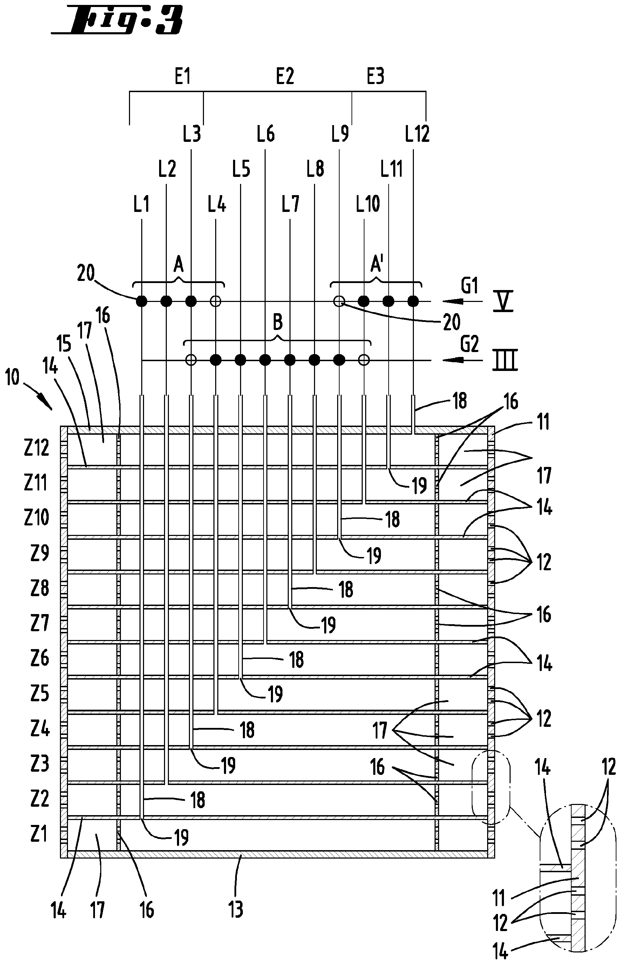

Das in der Figur 3 dargestellte Ausführungsbeispiel unterscheidet sich von dem in der Figur 2 dargestellten Ausführungsbeispiel im Wesentlichen dadurch, dass eine erste Gruppe A, A' von Gasleitungen L1 bis L4 beziehungsweise L9 bis L12 wahlweise nur mit der Speiseleitung G1 verbindbar ist und dass eine zweite Gruppe B von Gasleitungen L3 bis L10 wahlweise mit der Speiseleitung G2 verbindbar ist. Wesentlich ist, dass die Gasleitungen L3, L4 und L9, L10 sowohl der ersten Gruppe A als auch der zweiten Gruppe B angehören, so dass durch diese Gasleitungen L3, L4, L9, L10 wahlweise eine III- oder eine V-Verbindung eingespeist werden kann. Durch Umschalten der entsprechenden Ventile kann somit ein Gaseinlassbereich E2, durch die eine III-Verbindung in die Prozesskammer eingeleitet wird, oder die beiden Gaseinlassbereiche E1, E2, durch die eine V-Verbindung in die Prozesskammer eingeleitet wird, vergrößert oder verkleinert werden. Dies erfolgt lediglich durch Umschalten von Ventilen.

Bei dem in der Figur 3 dargestellten Ausführungsbeispiel können aber auch weitere Speiseleitungen vorgesehen sein, mit denen ein Inertgas an verschiedenen Kreuzungspunkten (Ventilen) in die Gasleitungen L1 bis L12 eingespeist werden. Mit den an den Schnittstellen L3/G1, L4/G1, L3/G2 und L4/G2 angeordneten Ventilen können die Höhen der Gaseinlassbereiche E1 und E2 verändert werden. Mit den an den Schnittstellen L9/G1, L9/G2, L10/G1 und L10/G2 angeordneten Ventilen 20 können die Höhen der Gaseinlassbereiche E2 und E3 variiert werden.

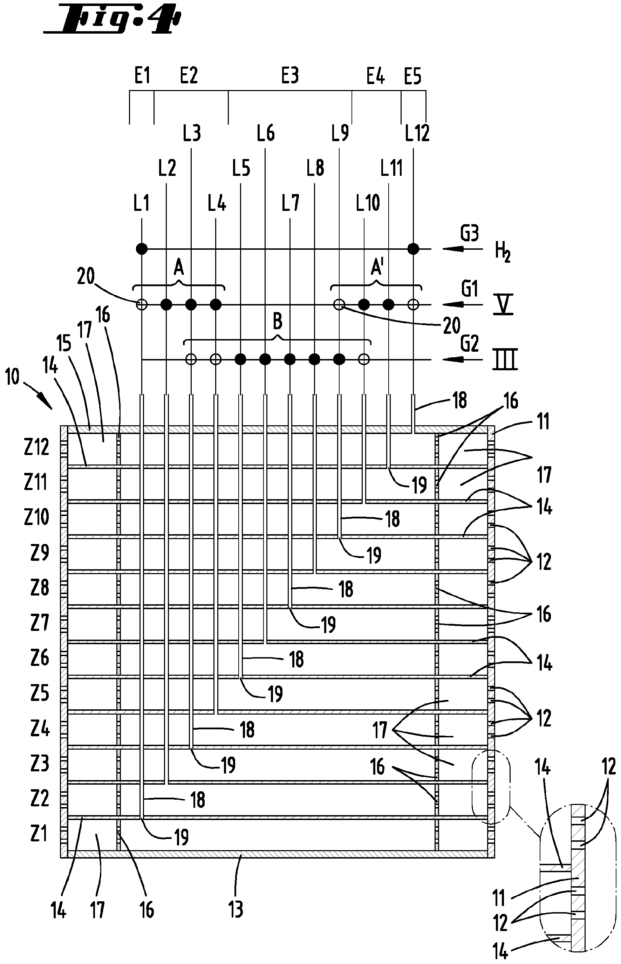

Das in der Figur 4 dargestellte Ausführungsbeispiel unterscheidet sich von dem in der Figur 2 beziehungsweise der Figur 3 dargestellten Ausführungsbeispiel im Wesentlichen dadurch, dass mit einer Speiseleitung G3 zusätzlich H₂ in die oberste oder unterste Gasaustrittszone Z1 beziehungsweise Z12 eingespeist werden kann. In diesem Fall wird in die unterste Gasaustrittszone Z1 beziehungsweise die oberste Gasaustrittszone Z12 kein Prozessgas der Gruppe III oder Gruppe V eingespeist.

Hier sind fünf Gaseinlassbereiche E1, E2, E3, E4, E5 vorgesehen, wobei der Gaseinlassbereich E1 nur eine einzige Gasaustrittszone Z1 aufweist, in die Wasserstoff eingespeist wird. Auch der Gaseinlassbereich E5 besitzt nur eine einzige Gasaustrittszone Z12, durch die Wasserstoff in die Prozesskammer 29 eingespeist wird. Der Gaseinlassbereich E2 besitzt drei Gasaustrittszonen Z2 bis Z4, kann aber durch Änderung der Ventilstellung auf eine Gasaustrittszone Z2 verkleinert werden oder auf vier Gasaustrittszonen Z1 bis Z4 vergrößert werden. Der Gaseinlassbereich E3 kann maximal acht Gasaustrittszonen Z3 bis Z9 aufweisen. Bei der Ventilstellung gemäß Figur 4 besitzt der Gaseinlassbereich E3 aber nur fünf Gasaustrittszonen Z5 bis Z9. Der Gaseinlassbereich E4 kann maximal vier Gasaustrittszonen Z8 bis Z12 aufweisen. Beim Ausführungsbeispiel sind die Ventile aber so geschaltet, dass der Gaseinlassbereich E4 nur zwei Gasaustrittszonen Z10, Z11 aufweist. Die zugehörige Gaseinlassvorrichtung besitzt Gasaustrittszonen Z1 bis Z12, die eine einheitliche Höhe besitzen, so dass durch Umschalten der Ventile Gaseinlassbereiche mit unterschiedlicher Höhe eingestellt werden können. Dies kann während eines Abscheideprozesses, beispielsweise beim Wechseln von Prozessgasen zum Abscheiden qualitativ verschiedener Schichten erfolgen.

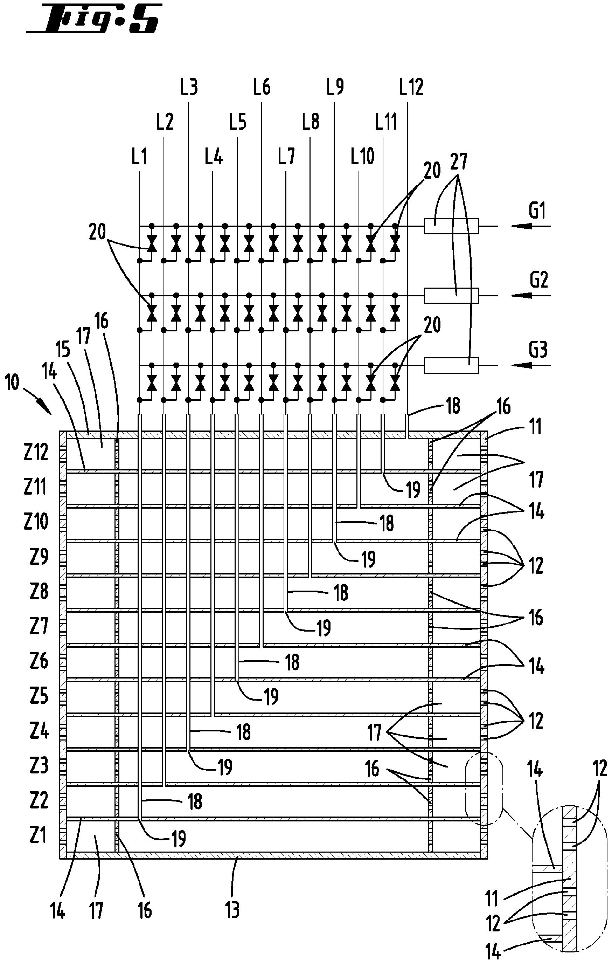

Die Figur 5 zeigt schematisch ein Beispiel einer Gasmischvorrichtung zur Realisierung der zuvor beschriebenen Ausführungsbeispiele. Ein von einer Gasquelle kommender Gasfluss wird in eine der Speiseleitungen G1, G2, G3 eingespeist. Mittels eines Massenflussreglers 27 wird der Massenfluss des Gases geregelt. Mit Ventilen 20 kann der Massenfluss auf verschiedene Gasaustrittszonen Z1 bis Z12 aufgeteilt werden. Hierzu sind die Speiseleitungen G1 bis G3 mit Ventilen mit den Gasleitungen L1 bis L12 verbunden, die jeweils in eine Zuleitung 18 münden, welche wiederum mit einer Mündungsöffnung 19 in ein Gasverteilvolumen 17 münden.

Auch hier kann durch eine Änderung der Ventilstellung der Ventile 20 die Anzahl und die Höhe einer Vielzahl von Gaseinlassbereichen E1 bis E5 verändert werden, wobei jeder Gaseinlassbereich E1 bis E5 dadurch gekennzeichnet ist, dass durch alle ihm zugeordneten Gasaustrittszonen Z1 bis Z12 dasselbe Prozessgas in die Prozesskammer fließt und alle Gasaustrittszonen Z1 bis Z12 eines Gaseinlassbereiches E1 bis E5 aneinander angrenzen, also eine einheitliche, zusammenhängende Gasaustrittsfläche bilden. Unter Höhe eines Gaseinlassbereiches E1 bis E5 wird erfindungsgemäß ein Abschnitt einer sich senkrecht zur Oberseite des Suszeptors 2 erstreckende Prozesskammerhöhe verstanden. Diese kann durch Umstellen von Umstellelementen variiert werden, wobei die Umstellelemente Ventile sein können.

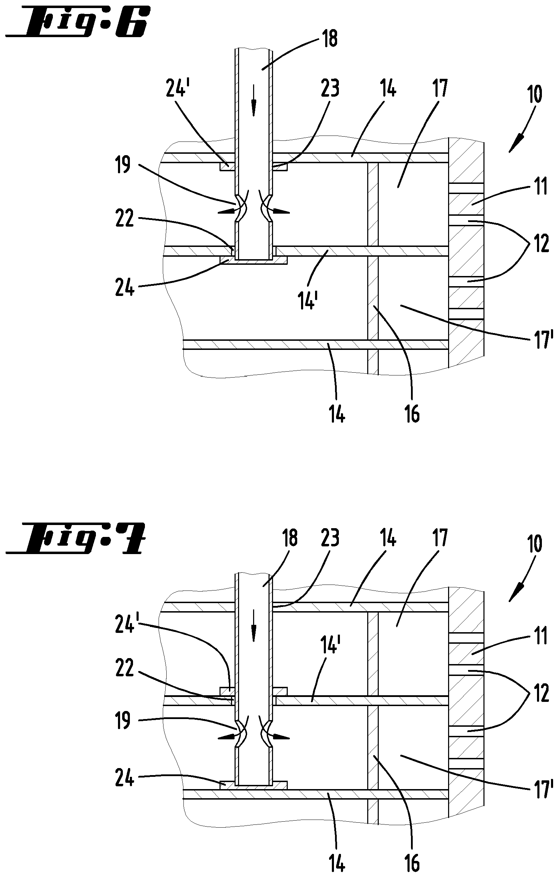

Das in den Figuren 6 und 7 dargestellte Ausführungsbeispiel zeigt einen Ausschnitt einer Gaseinlassvorrichtung 10. Eine als Rohr ausgebildete Zuleitung 18 kann in axialer Richtung verlagert werden. Die Zuleitung 18 besitzt Anschläge 24, 24', die in den beiden Endstellungen, die in den Figuren 6 und 7 dargestellt sind, jeweils einen Boden 14, 14' berühren. In der in der Figur 6 dargestellten Stellung mündet eine Mündung 19 der Zuleitung 18 in ein oberes Gasverteilvolumen 17. In der in Figur 7 dargestellten Stellung mündet die Mündung 19 der Zuleitung 18 in ein darunterliegendes Gasvolumen 17'. Beim Umstellen wird eine nicht dargestellte mechanische Umschaltvorrichtung verwendet, die die Zuleitung 18 durch eine Bohrung 23 des Bodens 14 verlagert. Mit der Zuleitung 18 kann hier wahlweise ein Prozessgas oder ein Inertgas in aneinander angrenzende Gasverteilvolumina 17, 17' eingespeist werden.

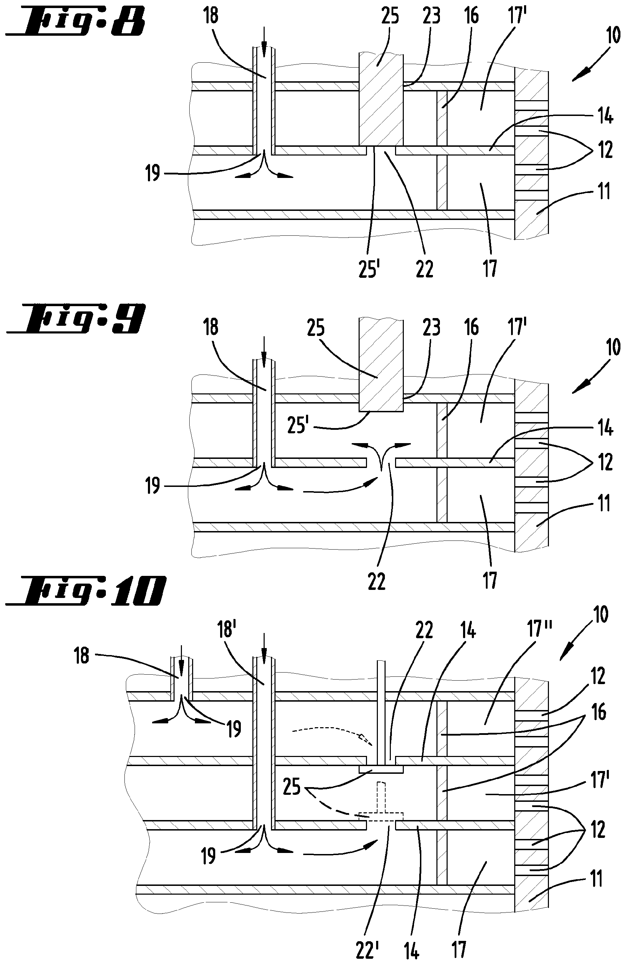

Bei dem in den Figuren 8 und 9 dargestellten Ausführungsbeispiel mündet eine Zuleitung 18 in ein unteres Gasverteilvolumen 17. In das darüber liegende Gasverteilvolumen 17' mündet keine Zuleitung 18. Der Boden 14 zwischen den beiden Gasverteilvolumina 17, 17' besitzt eine Öffnung 22, die in der in Figur 8 dargestellten Stellung von einer Stirnfläche 25' eines Verschlusselementes 25 gasdicht verschlossen ist. Das Verschlusselement 25 kann von einer nicht dargestellten mechanischen Umschaltvorrichtung in die in Figur 9 dargestellte Stellung verlagert werden, in der die Öffnung 22 frei ist, so dass Prozessgas von dem Gasverteilvolumen 17 in das Gasverteilvolumen 17' strömen kann.

Alternativ dazu kann aber auch eine Zuleitung 18 vorgesehen sein, die in das obere Gasverteilvolumen 17' mündet, so dass durch die Öffnung 22 eine Mischung stattfindet. Es kann aber auch vorgesehen sein, dass bei geöffneter Öffnung 22 durch lediglich eine der Zuleitungen 18 ein Prozessgas fließt. In einem nicht dargestellten Ausführungsbeispiel kann oberhalb des Gasverteilvolumens 17' ein weiteres Gasverteilvolumen 17" vorgesehen sein, in das eine Zuleitung 18 mündet. Mit einem weiteren Verschlusselement ähnlich des Verschlusselementes 25 kann eine weitere Öffnung in einem Boden zwischen den Volumina 17', 17" geöffnet oder verschlossen werden. Mit einer derartigen Anordnung kann eine Wechsel-Schaltung realisiert werden, mit der jeweils zwei der drei Volumina 17', 17" zusammen geschaltet werden können.

Bei dem in der Figur 10 dargestellten Ausführungsbeispiel grenzen an ein Gasverteilvolumen 17' zwei Gasverteilvolumina 17 an, die mit voneinander verschiedenen Prozessgasen gespeist werden können. In die Gasverteilvolumina 17 münden die Zuleitungen 18,18'. Das Gasverteilvolumen 17' kann mit einem Verschlusselement 25, das die Funktion eines Umschaltventil aufweist, wahlweise in eine Strömungsverbindung mit dem oberen Gasverteilvolumen 17" oder dem unteren Gasverteilvolumen 17 gebracht werden. Hierzu fluchten in zwei einander benachbarten Böden 14 angeordnete Öffnungen 22 miteinander, zwischen denen sich das Verschlusselement 25 bewegen kann, um jeweils eine Öffnung 22 zu verschließen, während die andere Öffnung 22' geöffnet ist.

Wie bei dem in den Figuren 8 und 9 dargestellten Ausführungsbeispiel können bei dem in Figur 10 dargestellten Ausführungsbeispiel mechanische Betätigungselemente vorgesehen sein, mit denen das Verschlusselement 25 bzw. ein Schaft des Verschlusselementes 25 mechanisch verlagert werden kann.

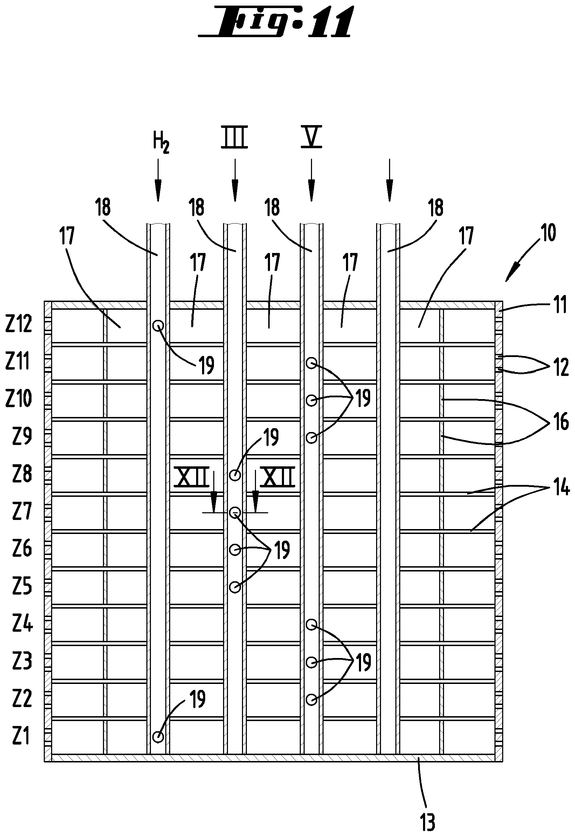

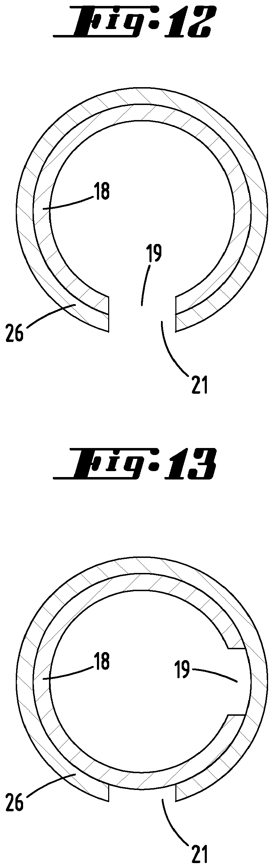

Das in den Figuren 11 bis 13 dargestellte Ausführungsbeispiel besitzt eine Mehrzahl von sich bevorzugt durch die gesamte axiale Erstreckung der Gaseinlassvorrichtung 10 erstreckenden Zuleitungen 18. Die Zuleitungen 18 besitzen ein oder mehrere radiale Öffnungen 19, die in jeweils eine Gasaustrittszone Z1 bis Z12 münden. Die Zuleitungen 18 können als um ihre Achse drehbare Rohre ausgebildet sein, die an voneinander verschiedenen azimutalen Positionen Öffnungen 19 aufweisen können. Durch Drehen der die Zuleitung 18 bildenden Rohre können die Öffnungen 19 mit Austrittsöffnungen 21 eines Außenrohres 26 in eine Überdecktlage gebracht werden. Die Zuleitung 18 ist hierzu innerhalb des Außenrohres angeordnet (Figur 12). In einer anderen Drehstellung der Zuleitung 18 (Figur 13) ist die Öffnung 19 geschlossen. Durch Drehen oder alternativ durch axiales Verlagern der die Zuleitungen 18 bildenden Rohre können in die Gasverteilvolumina 17 verschiedene Prozessgase eingespeist werden. Zum Verstellen der Zuleitungen 18 können mechanische Umschaltvorrichtungen vorgesehen sein. Alternativ dazu können aber auch die Außenrohre 26 in analoger Weise gedreht werden, so dass die Öffnungen 19, 21 miteinander fluchten oder jeweils von Wänden des anderen Rohres 18, 26 verschlossen sind.

Bei dem in den Figuren 6 bis 13 dargestellten Ausführungsbeispiel sind nicht dargestellte mechanische Antriebsmittel vorgesehen, mit denen die Umschaltelemente verlagert werden können, um die Anzahl der Gasaustrittszonen eines Gaseinlassbereiches zu ändern und damit die Höhe der Gaseinlassbereiche zu variieren.

Es wird als besonderer Vorteil der Erfindung angesehen, dass mittels innerhalb oder außerhalb eines Reaktorgehäuses angeordneten Umschaltelementen die wirksame Größe der Gasaustrittsfläche eines Gaseinlassbereiches E1 bis E5 verändert werden kann. Dies erfolgt bevorzugt durch Zu-, Ab- oder Umschalten ein oder mehrerer Zuleitungen 18, wobei das Zu- oder Abschalten bevorzugt mittels Ventilen 20 erfolgt, die in einem Gasmischsystem angeordnet sein können. Die Gaseinlassbereiche E1 bis E5 bilden insgesamt einen sich auf einer Zylindermantelwand erstreckenden Gasaustrittsbereich aus, der von einer Vielzahl, bevorzugt gleichgestalteten, Gasaustrittszonen Z1 bis Z12 gebildet ist. Die Gasaustrittszonen Z1 bis Z12 können in unterschiedlichen Kombinationen zu zusammenhängenden Gaseinlassbereichen E1 bis E5 kombiniert werden. Hierzu ist es von Vorteil, wenn zumindest in einige der Gasverteilvolumina 17, nämlich solche, die wahlweise voneinander verschiedenen Gaseinlassbereichen E1 bis E5 zugeordnet werden können, jeweils individuell Zuleitungen 18 münden, die wahlweise mit verschiedenen Speiseleitungen G1 bis G4 in Strömungsverbindung gebracht werden können.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können, nämlich:

Eine Gasverteilvorrichtung mit mehreren übereinander angeordneten Gaseinlassbereichen E1 bis E5, aus denen voneinander verschiedene Prozessgase oder zumindest ein Trägergas in eine Prozesskammer 7 eines CVD-Reaktors eintreten können, mit mindestens fünf etagenartig übereinander angeordneten Gasaustrittszonen Z1 bis Z12, jeweils aufweisend ein von einem Gasfluss speisbares Gasverteilvolumen 17, das von einem benachbarten Gasverteilvolumen 17' durch einen Zwischenboden 14 getrennt ist und eine Gasaustrittswand 11 mit Gasaustrittsöffnungen 12 aufweist, wobei die Gasaustrittswände 11 der Gasaustrittszonen Z1 bis Z12 in dieselbe Richtung weisen, und mehrere aneinander angrenzende Gasaustrittswände 11 zusammen einen Gaseinlassbereich E1 bis E5 ausbilden, durch den jeweils ein einheitliches Prozessgas in die Prozesskammer 7 austritt, wobei durch Zu-, Ab- oder Um-Schalten ein oder mehrerer der Zuleitungen 18, durch die Prozessgase in die Gasverteilvolumina 17 einspeisbar sind, die Höhe der Gaseinlassbereiche E1 bis E5 einstellbar ist.

Eine Gasverteilvorrichtung, die dadurch gekennzeichnet ist, dass jede Gasaustrittszone Z1 bis Z12 eine in das Gasverteilvolumen 17, 17' mündende Zuleitung 18 aufweist, wobei die Zuleitung 18 mit einer Speiseleitung G1 bis G4 zum Einspeisen eines Trägergases oder Prozessgases verbindbar ist und wobei einander benachbarte Gasaustrittszonen Z1 bis Z12 durch einen Boden 14, 14' voneinander getrennt sind, oder, dass zumindest einige der Gasaustrittszonen Z1 bis Z12 wahlweise mit verschiedenen Speiseleitungen G1 bis G4 strömungsverbindbar sind.

Eine Gasverteilvorrichtung, die dadurch gekennzeichnet ist, dass Gasaustrittszonen Z1 bis Z4, Z9 bis Z12 einer ersten Gruppe A, A' mittels Ventilen 20 mit einer ersten Speiseleitung G1 verbindbar sind und dass Gasaustrittszonen Z3 bis Z10 einer zweiten Gruppe B mittels Ventilen 20 mit einer zweiten Speiseleitung G2 verbindbar sind, wobei zumindest einige der Gasaustrittszonen Z3, Z4, Z9, Z10 wahlweise mit der ersten Speiseleitung G1 oder der zweiten Speiseleitung G2 verbindbar sind.

Eine Gasverteilvorrichtung, die dadurch gekennzeichnet ist, dass zwei oder mehr voneinander verschiedene Gasaustrittszonen Z1 bis Z12 wahlweise miteinander strömungsverbindbar sind.

Eine Gasverteilvorrichtung, die gekennzeichnet ist durch mechanische Umschaltelemente, mit denen wahlweise eine Öffnung 19 einer Zuleitung 18 oder eine Öffnung 22, 22' zwischen zwei oder mehr Gasaustrittszonen Z1 bis Z12 zwischen einer geöffneten oder einer verschlossenen Stellung umschaltbar sind.

Eine Gasverteilvorrichtung, die dadurch gekennzeichnet ist, dass mindestens fünf oder mindestens acht oder mindestens zehn oder mindestens zwölf Gasaustrittszonen Z1 bis Z12 vorgesehen sind.

Eine Gasverteilvorrichtung, die dadurch gekennzeichnet ist, dass jede der Gasaustrittszonen Z1 bis Z12 eine ihr individuell zugeordnete Zuleitung 18, 18' aufweist und jede Zuleitung 18, 18' mit einer Gasleitung L1 bis L12 eines Gasmischsystems verbunden ist, wobei zumindest eine Mehrzahl der Zuleitungen 18, 18' über mehrere Ventile 20 mit einer von mehreren Speiseleitungen G1 bis G4 strömungsverbindbar sind, wobei jede der Speiseleitungen G1 bis G4 einen Massenflusscontroller 27 aufweist.

Eine Gasverteilvorrichtung, die dadurch gekennzeichnet ist, dass ein eine Zuleitung 18 ausbildendes Rohr in einer Richtung quer zur Erstreckungsebene eines Bodens 14, 14' derart verlagerbar ist, dass eine Mündung 19 der Zuleitung 18 wahlweise in eines von zwei Gasverteilvolumina 17, 17' mündet.

Eine Gasverteilvorrichtung, die dadurch gekennzeichnet ist, dass ein eine Zuleitung 18 ausbildendes Rohr ein oder mehrere Öffnungen 19 aufweist, die in ein Gasverteilvolumen 17 münden und die durch Drehen des Rohres oder eines Außenrohres 26, in welchem das Rohr steckt, verschließbar ist.

Eine Gasverteilvorrichtung, die dadurch gekennzeichnet ist, dass eine Öffnung 22 in einem Boden 14 zwischen zwei Gasverteilvolumina 17, 17' mittels eines Verschlusselementes 25 wahlweise geöffnet oder geschlossen werden kann.

Eine Gasverteilvorrichtung, die dadurch gekennzeichnet ist, dass mit mechanischen Umschaltelementen Zuleitungen 18 und/ oder Verschlusselemente 25 innerhalb der Gaseinlassvorrichtung ortsverlagerbar sind.

Ein Verfahren, das gekennzeichnet ist durch die Verwendung einer Gasverteilvorrichtung gemäß einem der vorhergehenden Ansprüche, wobei die Höhe der Gaseinlassbereiche E1 bis E5 durch Zusammenschalten mehrerer aneinander angrenzender Gasaustrittszonen Z1 bis Z12 eingestellt wird.

Einen CVD-Reaktor, der dadurch gekennzeichnet ist, dass eine Gaseinlassvorrichtung gemäß einem der vorhergehenden Ansprüche im Zentrum der Prozesskammer 7 angeordnet ist, wobei die Gasaustrittswände 11 der zwischen Prozesskammerboden und Prozesskammerdecke übereinander angeordneten Gasaustrittszonen Z1 bis Z12 in einer gemeinsamen Zylindermantelfläche liegende Gasaustrittswände 11 aufweisen.

Eine Anordnung, die dadurch gekennzeichnet ist, dass das Gasmischsystem Speiseleitungen G1 bis G4 aufweist, die jeweils mit einer Quelle eines anderen Prozessgases oder eines Trägergases verbunden sind, wobei mehrere Gasleitungen L1 bis L12, die jeweils ein Gasverteilvolumen 17 einer Gasaustrittszone Z1 bis Z12 mit einem der Prozessgase oder dem Trägergas speisen, wobei eine Mehrzahl der Gasleitungen L1 bis L12 jeweils mit einem Ventil 20 mit einer Mehrzahl der Speiseleitungen G1 bis G4 jeweils derart strömungsverbunden ist, dass durch Variation der Stellung der Ventile 20 wahlweise verschiedene Prozessgase oder das Trägergas in einzelne der Gasverteilvolumina 17 einspeisbar sind.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren, auch ohne die Merkmale eines in Bezug genommenen Anspruchs, mit ihren Merkmalen eigenständige erfinderische Weiterbildungen des Standes der Technik, insbesondere um auf Basis dieser Ansprüche Teilanmeldungen vorzunehmen. Die in jedem Anspruch angegebene Erfindung kann zusätzlich ein oder mehrere der in der vorstehenden Beschreibung, insbesondere mit Bezugsziffern versehene und/oder in der Bezugsziffernliste angegebene Merkmale aufweisen. Die Erfindung betrifft auch Gestaltungsformen, bei denen einzelne der in der vorstehenden Beschreibung genannten Merkmale nicht verwirklicht sind, insbesondere soweit sie erkennbar für den jeweiligen Verwendungszweck entbehrlich sind oder durch andere technisch gleichwirkende Mittel ersetzt werden können.

### Liste der Bezugszeichen

| | | | |
|---|---|---|---|
| 1 | Reaktorgehäuse | 23 | Bohrung |
| 2 | Suszeptor | 24 | Anschlag |
| 3 | Heizeinrichtung | 24' | Anschlag |
| 4 | Substrathalter | 25 | Verschlusselement |
| 5 | Tasche | 25' | Verschlusselement |
| 6 | Schaft | 26 | Außenrohr |
| 7 | Prozesskammer | 27 | Massenflusscontroller |
| 8 | Prozesskammerdecke | | |
| 9 | Substrat | | |
| 10 | Gaseinlassvorrichtung | A | erste Gruppe |
| 11 | Gasaustrittswand | A' | erste Gruppe |
| 12 | Gasaustrittsöffnung | B | zweite Gruppe |
| 13 | Boden | E1-E5 | Gaseinlassbereich |
| 14 | Boden | L1-L12 | Gasleitung |
| 14' | Boden | G1-G4 | Speiseleitung |
| 15 | Decke | Z1-Z12 | Gasaustrittszone |
| 16 | Barriere | | |
| 17 | Gasverteilvolumen | | |
| 17' | Gasverteilvolumen | | |
| 18 | Zuleitung | | |
| 18' | Zuleitung | | |
| 19 | Mündung | | |
| 20 | Ventil | | |
| 21 | Austrittsöffnung | | |
| 22 | Öffnung | | |
| 22' | Öffnung | | |

## Patentansprüche

1. Gasverteilvorrichtung mit mehreren übereinander angeordneten Gaseinlassbereichen (E1 bis E5), aus denen voneinander verschiedene Prozessgase oder zumindest ein Trägergas in eine Prozesskammer (7) eines CVD-Reaktors eintreten können, mit mindestens fünf etagenartig übereinander angeordneten Gasaustrittszonen (Z1 bis Z12), jeweils aufweisend ein Gasverteilvolumen (17), in das eine Zuleitung (18) zum Einspeisen eines Gasflusses mündet, das von einem benachbarten Gasverteilvolumen (17, 17', 17") durch einen Zwischenboden (14) getrennt ist und eine Gasaustrittswand (11) mit Gasaustrittsöffnungen (12) aufweist, wobei die Gasaustrittswände (11) der Gasaustrittszonen (Z1 bis Z12) in dieselbe Richtung weisen, und mehrere aneinander angrenzende Gasaustrittswände (11) zusammen einen Gaseinlassbereich (E1 bis E5) ausbilden, durch den jeweils ein einheitliches Prozessgas in die Prozesskammer (7) austritt, wobei
den Zuleitungen (18) Ventile (20) oder mechanische Umschaltelemente derart zugeordnet sind, dass durch Zu-, Ab- oder Um-Schalten ein oder mehrerer Zuleitungen (18), die Höhe der Gaseinlassbereiche (E1 bis E5) einstellbar ist.

2. Gasverteilvorrichtung nach Anspruch 1, **dadurch gekennzeichnet, dass** die Zuleitung (18) mit einer Speiseleitung (G1 bis G4) zum Einspeisen eines Inertgases oder Prozessgases verbindbar ist, wobei zumindest einige Gasaustrittszonen (Z1 bis Z12) durch einen Boden (14, 14') voneinander getrennt sind, oder, dass zumindest einige der Gasaustrittszonen (Z1 bis Z12) wahlweise mit verschiedenen Speiseleitungen (G1 bis G4) strömungsverbindbar sind.

3. Gasverteilvorrichtung nach einem der vorhergehenden Ansprüche, **dadurch gekennzeichnet, dass** Gasaustrittszonen (Z1 bis Z4, Z9 bis Z12) einer ersten Gruppe (A, A') mittels der Ventile (20) mit einer ersten Speiseleitung (G1) verbindbar sind und dass Gasaustrittszonen (Z3 bis Z10) einer zweiten Gruppe (B) mittels der Ventile (20) mit einer zweiten Speiseleitung (G2) verbindbar sind, wobei zumindest einige der Gasaustrittszonen (Z3, Z4, Z9, Z10) wahlweise mit der ersten Speiseleitung (G1) oder der zweiten Speiseleitung (G2) verbindbar sind.

4. Gasverteilvorrichtung nach einem der vorhergehenden Ansprüche,
**dadurch gekennzeichnet, dass** zwei voneinander verschiedene Gasaustrittszonen (Z1 bis Z12) wahlweise miteinander strömungsverbindbar sind.

5. Gasverteilvorrichtung nach Anspruch 1, **dadurch gekennzeichnet, dass** mit den mechanischen Umschaltelementen wahlweise eine Öffnung (19) einer Zuleitung (18) oder eine Öffnung (22, 22') zwischen zwei Gasaustrittszonen (Z1 bis Z12) zwischen einer geöffneten oder einer verschlossenen Stellung umschaltbar sind.

6. Gasverteilvorrichtung nach einem der vorhergehenden Ansprüche, **dadurch gekennzeichnet, dass** jede der Gasaustrittszonen (Z1 bis Z12) eine ihr individuell zugeordnete Zuleitung (18, 18') aufweist und jede Zuleitung (18, 18') mit einer Gasleitung (L1 bis L12) eines Gasmischsystems verbunden ist, wobei zumindest eine Mehrzahl der Zuleitungen (18, 18') über mehrere Ventile (20) mit einer von mehreren Speiseleitungen (G1 bis G4) strömungsverbindbar sind, wobei jede der Speiseleitungen (G1 bis G4) einen Massenflusscontroller (27) aufweist.

7. Gasverteilvorrichtung nach Anspruch 1, **dadurch gekennzeichnet, dass** die mechanischen Umschaltelemente von einem zumindest eine Zuleitung (18) ausbildenden Rohr gebildet sind, das in einer Richtung quer zur Erstreckungsebene eines Bodens (14, 14') derart verlagerbar ist, dass eine Mündung (19) der Zuleitung (18) wahlweise in eines von zwei Gasverteilvolumina (17, 17') mündet.

8. Gasverteilvorrichtung nach Anspruch 1, **dadurch gekennzeichnet, dass** die mechanischen Umschaltelemente von zumindest einem eine Zuleitung (18) ausbildenden Rohr gebildet sind, das ein oder mehrere Öffnungen (19) aufweist, die in ein Gasverteilvolumen (17) münden und die durch Drehen des Rohres oder eines Außenrohres (26), in welchem das Rohr steckt, verschließbar ist.

9. Gasverteilvorrichtung nach Anspruch 1, **dadurch gekennzeichnet, dass** die mechanischen Umschaltelemente von einem Verschlusselement (25) gebildet sind, mittels dessen eine Öffnung (22) in einem Boden (14) zwischen zwei Gasverteilvolumina (17, 17') wahlweise geöffnet oder geschlossen werden kann.

10. Gasverteilvorrichtung nach einem der vorhergehenden Ansprüche, **dadurch gekennzeichnet, dass** mit mechanischen Umschaltelementen Zuleitungen (18) und/oder Verschlusselemente (25) innerhalb der Gaseinlassvorrichtung ortsverlagerbar sind.

11. Verfahren zum Einspeisen von Prozessgasen in eine Prozesskammer (7) eines CVD-Reaktors, **gekennzeichnet durch** die Verwendung einer Gasverteilvorrichtung gemäß einem der vorhergehenden Ansprüche, wobei die Höhe der Gaseinlassbereiche (E1 bis E5) durch Zusammenschalten mehrerer aneinander angrenzender Gasaustrittszonen (Z1 bis Z12) eingestellt wird.

12. CVD-Reaktor mit einem um eine Drehachse drehbaren Suszeptor (2), der zu einer Prozesskammer (7) offene Taschen (5) aufweist, in der jeweils ein Substrathalter (4) einliegt, wobei sich die Prozesskammer (7) zwischen dem Suszeptor (2) und einer Prozesskammerdecke (8) erstreckt, **dadurch gekennzeichnet, dass** eine Gaseinlassvorrichtung gemäß einem der vorhergehenden Ansprüche im Zentrum der Prozesskammer (7) angeordnet ist, wobei die Gasaustrittswände (11) der zwischen Prozesskammerboden und Prozesskammerdecke übereinander angeordneten Gasaustrittszonen (Z1 bis Z12) in einer gemeinsamen Zylindermantelfläche liegende Gasaustrittswände (11) aufweisen.

13. Anordnung bestehend aus einem CVD-Reaktor gemäß Anspruch 12 und einem Gasmischsystem, **dadurch gekennzeichnet, dass** das Gasmischsystem Speiseleitungen (G1 bis G4) aufweist, die jeweils mit einer Quelle eines anderen Prozessgases oder eines Trägergases verbunden sind, wobei mehrere Gasleitungen (L1 bis L12), die jeweils ein Gasverteilvolumen (17) einer Gasaustrittszone (Z1 bis Z12) mit einem der Prozessgase oder dem Trägergas speisen, wobei eine Mehrzahl der Gasleitungen (L1 bis L12) jeweils mit einem Ventil (20) mit einer Mehrzahl der Speiseleitungen (G1 bis G4) jeweils derart strömungsverbunden ist, dass durch Variation der Stellung der Ventile (20) wahlweise verschiedene Prozessgase oder das Trägergas in einzelne der Gasverteilvolumina (17) einspeisbar sind.

## Claims

1. A gas distribution device having multiple gas inlet regions (E1 to E5), which are arranged on top of one another and from which different process gases or at least one carrier gas can be introduced into a process chamber (7) of a CVD reactor, with at least five gas outlet zones (Z1 to Z12) that are arranged on top of one another at different levels and respectively have a gas distribution volume (17), into which a supply conduit (18) for introducing a gas flow leads, wherein said gas distribution volume is separated from an adjacent gas distribution volume (17, 17', 17") by an intermediate base (14) and has a gas outlet wall (11) with gas outlet openings (12), and wherein the gas outlet walls (11) of the gas outlet zones (Z1 to Z12) point in the same direction and multiple adjacent gas outlet walls (11) jointly form a gas inlet region (E1 to E5), through which a uniform process gas respectively exits into the process chamber (7), wherein valves (20) or mechanical switchover elements, which are assigned to the supply conduits (18) in such a way that the height of the gas inlet regions (E1 to E5) can be adjusted by switching on, switching off or switching over one or more supply conduits (18).

2. The gas distribution device according to claim 1, **characterized in that** the supply conduit (18) can be connected to a feed conduit (G1 to G4) for introducing an inert gas or process gas, wherein at least a few gas outlet zones (Z1 to Z12) are separated from one another by a base (14, 14'), or **in that** at least a few of the gas outlet zones (Z1 to Z12) can be selectively connected to different feed conduits (G1 to G4) in a fluidic manner.

3. The gas distribution device according to one of the preceding claims, **characterized in that** gas outlet zones (Z1 to Z4, Z9 to Z12) of a first group (A, A') can be connected to a first feed conduit (G1) by means of the valves (20), and **in that** gas outlet zones (Z3 to Z10) of a second group (B) can be connected to a second feed conduit (G2) by means of the valves (20), wherein at least a few of the gas outlet zones (Z3, Z4, Z9, Z10) can be selectively connected to the first feed conduit (G1) or the second feed conduit (G2).

4. The gas distribution device according to one of the preceding claims, **characterized in that** two different gas outlet zones (Z1 to Z12) can be selectively connected to one another in a fluidic manner.

5. The gas distribution device according to claim 1, **characterized in that** an opening (19) of a supply conduit (18) or an opening (22, 22') between two gas outlet zones (Z1 to Z12) can be selectively switched over between an open or a closed position by means of the mechanical switchover elements.

6. The gas distribution device according to one of the preceding claims, **characterized in that** each of the gas outlet zones (Z1 to Z12) has an individually assigned supply conduit (18, 18') and each supply conduit (18, 18') is connected to a gas conduit (L1 to L12) of a gas mixing system, wherein at least a plurality of the supply conduits (18, 18') can be connected to one of multiple feed conduits (G1 to G4) in a fluidic manner by means of multiple valves (20), and wherein each of the feed conduits (G1 to G4) has a mass flow controller (27).

7. The gas distribution device according to claim 1, **characterized in that** the mechanical switchover elements are formed by a pipe, which forms at least one supply conduit (18) and can be displaced in a direction extending transverse to the plane of a base (14, 14') in such a way that a mouth (19) of the supply conduit (18) selectively opens into one of two gas distribution volumes (17, 17').

8. The gas distribution device according to claim 1, **characterized in that** the mechanical switchover elements are formed by at least one pipe, which forms a supply conduit (18) and has one or more openings (19), wherein said openings lead into a gas distribution volume (17) and can be closed by rotating the pipe or an outer pipe (26), into which the pipe is inserted.

9. The gas distribution device according to claim 1, **characterized in that** the mechanical switchover elements are formed by a closing element (25), by means of which an opening (22) in a base (14) between two gas distribution volumes (17, 17') can be selectively opened or closed.

10. The gas distribution device according to one of the preceding claims, **characterized in that** supply conduits (18) and/or closing elements (25) can be locally displaced within the gas inlet device by means of mechanical switchover elements.

11. A method for feeding process gases into a process chamber (7) of a CVD reactor, **characterized by** the utilization of a gas distribution device according to claim 1, wherein the height of the gas inlet regions (E1 to E5) is adjusted by interconnecting multiple gas outlet zones (Z1 to Z12) that border on one another.

12. A CVD reactor with a susceptor (2) that is rotatable about a rotational axis and has pockets (5) that are open toward a process chamber (7), wherein a substrate holder (4) is respectively arranged in each of said pockets, and wherein the process chamber (7) extends between the susceptor (2) and a process chamber ceiling (8), **characterized in that** a gas distribution device according to claim 1 is arranged in the center of the process chamber (7), wherein the gas outlet walls (11) of the gas outlet zones (Z1 to Z12), which are arranged on top of one another between the process chamber bottom and the process chamber ceiling, have gas outlet walls (11) that lie on a common cylinder shell surface.

13. An arrangement consisting of a CVD reactor according to claim 12 and a gas mixing system, **characterized in that** the gas mixing system has feed conduits (G1 to G4), which are respectively connected to a source of a different process gas or a carrier gas, wherein multiple gas conduits (L1 to L12) respectively feed one of the process gases or the carrier gas into a gas distribution volume (17) of a gas outlet zone (Z1 to Z12), and wherein a plurality of the gas conduits (L1 to L12) is respectively connected to a plurality of the feed conduits (G1 to G4) in a fluidic manner by means of a respective valve (20) in such a way that different process gases or the carrier gas can be selectively fed into individual gas distribution volumes (17) by varying the position of the valves (20).

## Revendications

1. Dispositif de distribution de gaz avec plusieurs zones d'admission de gaz (E1 à E5) disposées l'une sur l'autre à partir desquelles des gaz de traitement différents l'un de l'autre ou au moins un gaz porteur peuvent entrer dans une chambre de traitement (7) d'un réacteur à dépôt chimique en phase vapeur (DCV), avec au moins cinq zones de sortie de gaz (Z1 à Z12) disposées l'une sur l'autre de façon étagée, comprenant respectivement un volume de distribution de gaz (17), dans lequel débouche une conduite d'arrivée (18) pour l'alimentation en flux de gaz, qui est séparée d'un volume de distribution de gaz (17, 17', 17") voisin par un fond intermédiaire (14) et comporte une paroi de sortie de gaz (11) avec des ouvertures de sortie de gaz (12), sachant que les parois de sortie de gaz (11) des zones de sortie de gaz (Z1 à Z12) sont dirigées dans la même direction et plusieurs parois de sortie de gaz (11) adjacentes l'une à l'autre constituent ensemble une zone d'admission de gaz (E1 à E5) à travers laquelle sort respectivement un gaz de traitement uniforme dans la chambre de traitement (7), sachant que des soupapes (20) ou éléments d'inversion mécaniques sont attribués aux conduites d'arrivée (18) de telle manière que la hauteur des zones d'admission de gaz (E1 à E5) peut être réglée par l'ouverture, la fermeture ou l'inversion d'une ou plusieurs conduites d'arrivée (18).

2. Dispositif de distribution de gaz selon la revendication 1, **caractérisé en ce que** la conduite d'arrivée (18) peut être reliée à une conduite d'alimentation (G1 à G4) pour l'alimentation en gaz inerte ou en gaz de traitement, sachant qu'au moins plusieurs zones de sortie de gaz (Z1 à Z12) sont séparées l'une de l'autre par un fond (14, 14') ou **en ce qu'**au moins plusieurs des zones de sortie de gaz (Z1 à Z12) peuvent être reliées en écoulement selon nécessité aux différentes conduites d'alimentation (G1 à G4).

3. Dispositif de distribution de gaz selon l'une quelconque des revendications précédentes, **caractérisé en ce que** des zones de sortie de gaz (Z1 à Z4, Z9 à Z12) d'un premier groupe (A, A') peuvent être reliées au moyen des soupapes (20) à une première conduite d'alimentation (G1) et **en ce que** des zones de sortie de gaz (Z3 à Z10) d'un deuxième groupe (B) peuvent être reliées au moyen des soupapes (20) à une deuxième conduite d'alimentation (G2), sachant qu'au moins plusieurs des zones de sortie de gaz (Z3, Z4, Z9, Z10) peuvent être reliées selon nécessité à la première conduite d'arrivée (G1) ou à la deuxième conduite d'arrivée (G2).

4. Dispositif de distribution de gaz selon l'une quelconque des revendications précédentes, **caractérisé en ce que** deux zones de sortie de gaz différentes l'une de l'autre (Z1 à Z12) peuvent être reliées en écoulement l'une à l'autre selon nécessité.

5. Dispositif de distribution de gaz selon la revendication 1, **caractérisé en ce qu'**une ouverture (19) d'une conduite d'arrivée (18) ou une ouverture (22, 22') entre deux zones de sortie de gaz (Z1 à Z12) peuvent être inversées selon nécessité avec les éléments d'inversion mécaniques entre une position ouverte ou une position fermée.

6. Dispositif de distribution de gaz selon l'une quelconque des revendications précédentes, **caractérisé en ce que** chacune des zones de sortie de gaz (Z1 à Z12) comporte une conduite d'arrivée (18, 18') qui lui est individuellement attribuée et chaque conduite d'arrivée (18, 18') est reliée à une conduite de gaz (L1 à L12) d'un système de mélange de gaz, sachant qu'au moins de nombreuses conduites d'arrivée (18, 18') peuvent être reliées en écoulement par plusieurs soupapes (20) à une des nombreuses conduites d'alimentation (G1 à G4), sachant que chacune des conduites d'alimentations (G1 à G4) comporte un régulateur de débit massique (27).

7. Dispositif de distribution de gaz selon la revendication 1, **caractérisé en ce que** les éléments d'inversion mécaniques sont formés par au moins un tuyau constituant une conduite d'arrivée (18), qui peut être déplacé dans une direction transversalement au plan d'extension d'un fond (14, 14') de telle manière qu'une embouchure (19) de la conduite d'arrivée (18) débouche selon nécessité dans un des deux volumes de distribution de gaz (17, 17').

8. Dispositif de distribution de gaz selon la revendication 1, **caractérisé en ce que** les éléments d'inversion mécaniques sont formés par au moins un tuyau constituant une conduite d'arrivée (18), qui comporte une ou plusieurs ouvertures (19), qui débouchent dans un volume de distribution de gaz (17) et qui peuvent être fermées par la rotation du tuyau ou d'un tuyau extérieur (26), dans lequel s'emboîte le tuyau.

9. Dispositif de distribution de gaz selon la revendication 1, **caractérisé en ce que** les éléments d'inversion mécaniques sont formés par un élément de fermeture (25) au moyen duquel une ouverture (22) peut être ouverte ou fermée dans un fond (14) entre deux volumes de distribution de gaz (17, 17').

10. Dispositif de distribution de gaz selon l'une quelconque des revendications précédentes, **caractérisé en ce que** des conduites d'arrivée (18) et/ou des éléments de fermeture (25) peuvent être localement déplacés à l'intérieur du dispositif d'admission de gaz avec des éléments d'inversion mécaniques.

11. Procédé d'alimentation de gaz de traitement dans une chambre de traitement (7) d'un réacteur DCV, **caractérisé par** l'utilisation d'un dispositif de distribution de gaz selon l'une quelconque des revendications précédentes, sachant que la hauteur des zones d'admission de gaz (E1 à E5) est réglée par interconnexion de plusieurs zones de sortie de gaz (Z1 à Z12) limitrophes les unes des autres.

12. Réacteur de dépôt chimique en phase vapeur (DCV) avec un suscepteur (2) pouvant tourner autour d'un axe de rotation, qui comporte des poches (5) ouvertes vers une chambre de traitement (7) dans laquelle s'insère respectivement un support de substrat (4), sachant que la chambre de traitement (7) s'étend entre le suscepteur (2) et un plafond de chambre de traitement (8), **caractérisé en ce qu'**un dispositif d'admission de gaz selon l'une quelconque des revendications précédentes est disposé au centre de la chambre de traitement (7), sachant que les parois de sortie de gaz (11) des zones de sortie de gaz (Z1 à Z12) disposées l'une sur l'autre entre le fond de chambre de traitement et le plafond de chambre de traitement comportent des parois de sortie de gaz (11) se trouvant dans une surface d'enveloppe cylindrique commune.

13. Agencement composé d'un réacteur DCV selon la revendication 12, **caractérisé en ce que** le système de mélange de gaz comporte des conduites d'alimentation (G1 à G4), qui sont respectivement reliées à une source d'un autre gaz de traitement ou d'un gaz porteur, sachant que plusieurs conduites de gaz (L1 à L12), qui alimentent respectivement un volume de distribution de gaz (17) d'une zone de sortie de gaz (Z1 à Z12) avec un des gaz de traitement ou le gaz porteur, sachant que de nombreuses conduites de gaz (L1 à L12) sont respectivement reliées en écoulement à une soupape (20) avec une pluralité de conduites d'alimentation (G1 à G4) de telle manière que par variation de la position des soupapes (20), différents gaz de traitement ou le gaz porteurs peuvent être selon nécessité introduits dans des volumes de distribution de gaz individuels (17).
